**Europäisches Patentamt**

**European Patent Office**

**Office européen des brevets**

(19)

(11) Publication number : **0 537 144 B1**

## EUROPEAN PATENT SPECIFICATION

(12)

(45) Date of publication of patent specification :
21.06.95 Bulletin 95/25

(51) Int. Cl.⁶ : **G07C 3/04, H03M 1/82, H03K 3/00**

(21) Application number : **90910987.8**

(22) Date of filing : **09.07.90**

(86) International application number :
**PCT/US90/03833**

(87) International publication number :
**WO 91/01064 24.01.91 Gazette 91/03**

(54) **DATA ENCODEMENT AND READING METHOD AND APPARATUS.**

(30) Priority : **13.07.89 US 377571**

(43) Date of publication of application :
**21.04.93 Bulletin 93/16**

(45) Publication of the grant of the patent :
**21.06.95 Bulletin 95/25**

(84) Designated Contracting States :
**DE FR GB**

(56) References cited :
**US-A- 3 623 044**
**US-A- 3 673 552**
**US-A- 3 976 949**
**US-A- 4 107 667**
**US-A- 4 115 733**
**US-A- 4 591 810**

(56) References cited :
**US-A- 4 596 965**
**US-A- 4 873 672**
**US-A- 4 887 242**
**US-A- 4 904 883**

(73) Proprietor : **CURTIS INSTRUMENTS, INC.**
**200 Kisco Avenue**
**Mount Kisco, NY 10549 (US)**

(72) Inventor : **FINGER, Eugene, P.**
**Old Milltown Road**
**Brewster, NY 10509 (US)**

(74) Representative : **Blatchford, William Michael et al**
**Withers & Rogers**
**4 Dyer's Buildings**
**Holborn**
**London EC1N 2JT (GB)**

EP 0 537 144 B1

## Description

The present invention relates generally to a method and apparatus for "reading" one or more data signals and is primarily applicable to reading accumulated data in electronic form. In its preferred form, the invention provides a method and apparatus which are simple, accurate, and are especially well suited for field measurements by relatively unskilled technicians employing a commercially available, hand-held digital multi-meter.

There are many applications for data measurement which require reasonable accuracy, but which do not require the accuracy of most specialized date reading systems. One example of such an application is reading operating data measurements on a piece of machinery, such as, for example, a tractor having an internal combustion engine. Some data measurements of interest for that application could include total hours running time, total number of starts, total number of revolutions, and an integral function representing thermal stress or rotating stress over a period of time. The latter types of measurements, for example, may integrate a strain gage output with respect to time.

There are many known methods and apparatus for transducing such data to digital information for contemporaneous or subsequent transmission, storage, display, and/or processing. Such methods and apparatus, in many cases, require specialized components which are typically dedicated to a particular measurement or application, are expensive, and often require some degree of technical sophistication on the part of the user.

US Patent No. 4,712,195, issued December 8, 1987, titled "Solid-State Cumulative Operations Measurement System", assigned to the assignee of the present invention, the disclosure of which patent is made a part hereof by reference, describes a measurement system which accumulates and stores accumulated operations data in terms of either total elapsed time or digital counts. Briefly, the measurement system includes a volatile memory register which receives and stores input voltage signals representing operations data and a nonvolatile memory into which the count stored in the volatile memory is transferred when the voltage signals terminate. When data flow resumes, the count stored in the nonvolatile memory is transferred to the volatile memory. Means are included to protect the solid state circuitry employed from noise or non-operation oscillations in the input voltages. The patent also describes a reader for use with the system which reader activates a serial encoder in the system through which encoder data in the memories is made available in a digitally coded data bit stream. The measurement system described provides 1 part in 10 million resolution (referred to full scale), and an accuracy on the order of several parts per million, depending on crystal oscillator accuracy, but requires a special reader or a specially programmed computer interface which could be difficult or impossible for a relatively unskilled technician to use in the case of isolated field measurements.

In copending US Patent Application Serial No. 07/071,801, filed July 13, 1987, titled "Solid-State Reader Device For A Cumulative Operations Measurement System", and assigned to the assignee of the present invention, the disclosure of which application is made a part hereof by reference, there is described a reader that is particularly well suited for use with the system of the above-referenced patent.

Another type of operations measurement device is described in US Patent No. 3,665,308, issued May 23, 1972, titled "Package For An Electrochemical Elapsed Time Meter", and assigned to the assignee of the present invention, wherein an analog mercury coulometer tube is employed as an elapsed time indicator. A DC current passing through a column of mercury in the tube causes the movement of mercury molecules through an electrolyte gap in the column, with the resulting change in position of the meniscus of the mercury being the integral of DC current level with respect to time.

Instruments based on the disclosures of the above patents and application are manufactured by Curtis Instruments, Inc, Mt. Kisco, New York.

Other types of prior cumulative operations measurement systems are well known electro-mechanical devices in which synchronous motors or pulse circuits are used to advance mechanical counters.

The above types of devices and systems bracket the extremes of resolution and accuracy associated with contemporary timers and integrators. The bit serial elapsed timer/digital readout of Patent No. 4,712,195 and the bit serial reader of Application No. 07/071,801 are at the high end of resolution and accuracy. Typically, these would be dedicated components.

The analog mercury coulometer offers resolution and accuracy on the order of 1-2 parts per hundred, is relatively inexpensive, but is vulnerable to temperature changes and shock and vibration.

The electro-mechanical devices have slow response, limited resolution, and tend to be bulky and expensive.

It is a principal object of the present invention to provide a method and apparatus for reading operations measurement data which are economical and easy to employ.

According to a first aspect of this invention, a method of processing and reading a single data signal having a value and representing a parameter comprises: (a) electronically encoding the single data signal with a first variable indicating full-scale range of the said value; (b) electronically encoding the single data signal with a second variable indicating the magnitude of the said value; (c) reading the first variable in the single data signal to determine the full-scale range; and (d) reading the second variable in the single data signal to determine the said value.

According to another aspect of the invention apparatus for processing and reading a first single data signal having a value and representing a parameter comprises: (a) means for electronically encoding the first single data signal with a first variable indicating full-scale range of the said first value; (b) means for electronically encoding the first single data signal with a second variable indicating the magnitude of the first said value; (c) means for reading the first variable in the first single data signal to determine the full-scale range; and (d) means for reading the second variable in the first single data signal to determine the value of the data. Preferred features of the invention appear in the dependent claims following this description. The method and apparatus described hereinafter allow operations data to be measured using a commercially available digital multimeter (DMM) as the data receiving and display device. In one preferred embodiment, for example, basic operations data is transduced to digital form and then coded with a width modulator. The width modulated data may represent, for example, total elapsed time or total counts of a measured operation. The full-scale range of the data is encoded as frequency. A technician reads the frequency of the data signal with the DMM to determine the full-scale range of the data and then reads percent-of-range with the DMM as duty cycle. For multiple operations data, peak voltage is used as a parameter identifier. Alternatively, the value of the parameter being measured, the full-scale range, and the parameter identifier may be encoded as any combination of frequency, peak voltage, or duty cycle. One parameter, preferably frequency, may be encoded with additional information, such as data site and data channel. The data stream is amplitude modulated to indicate selected alarm levels. In addition, a unique method of resetting data storage is provided.

The invention will now be described by way of example with reference to the drawings. A brief description of the drawings follows.

Figure 1 is a partial schematic diagram of an embodiment of an operations measurement system disclosed in US Patent No. 4,712,195.

Figure 2 is a block diagram showing the basic operation of a preferred embodiment of the present invention.

Figure 3 is a block diagram showing one embodiment of the present invention using a digital multimeter to read data.

Figure 4 is a block diagram showing another embodiment of the present invention using a digital multimeter to read data.

Figure 5 is a block diagram showing an embodiment of the present invention in which data is encoded with an alarm level by means of selectively varying the amplitude of the data signal.

Figure 6 is a block diagram showing an embodiment of the present invention which may be employed to reset a data source.

Figures 7A and 7B are block diagrams illustrating a further embodiment of the present invention.

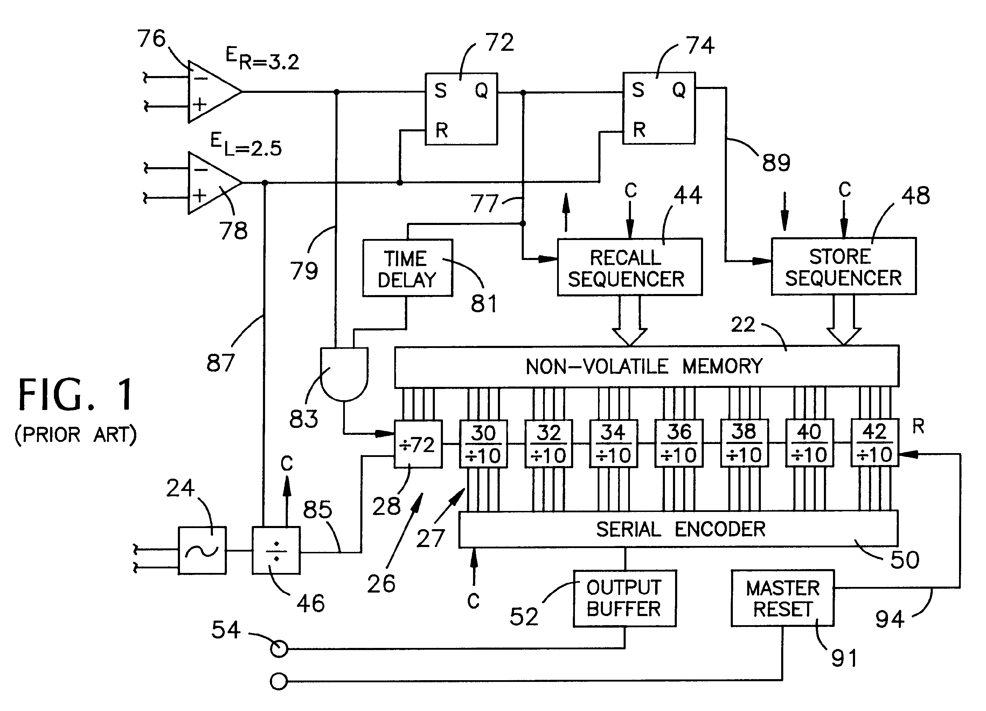

Referring now to the Drawings, Figure 1 shows a portion of one embodiment of the cumulative operations measurement system disclosed in above-referenced US Patent No. 4,712,195 (hereinafter "the Patent"), that embodiment limited to the measurement of total operating time. The system includes a nonvolatile memory 22, a 32.768-KHz. oscillator 24, and a volatile counter memory register 26, the latter including a series of stages 28-42 operating as digital divider circuits; all interconnected as shown. The divider circuit 28 preferably divides by a factor of 72. Each of the dividers 30-42 preferably divides by a factor of 10. The dividers 30-42 comprise a decimal register 27. The outputs of voltage comparison amplifiers 76 and 78 operate to control latch circuits 72 and 74 and, upon startup of the operation being measured, a recall sequencer 44 is activated to recall a count number previously stored in nonvolatile memory 22 and transfer it to volatile memory register 26 before commencement of the time measurement. Time is measured by means of timed pulses delivered from oscillator 24 to volatile memory register 26 through a divider circuit 46. When voltage is removed from the operations measurement system, store sequencer circuit 48 is activated to store in nonvolatile memory 22 the count number in volatile memory register 26. Volatile memory register is reset through a signal to a master reset 91.

When it is desired to read data in the system of the Patent, a serial encoder 50 provides a stream of serial bit data through an output buffer 52 to output terminal 54. If the system is not active at the time of reading, the reader furnishes sufficient power to the system to activate recall sequencer 44 and transfer the data from nonvolatile memory 22 to volatile memory register 26 so that it may be read.

Another embodiment of the system of the Patent may be employed to collect either total elapsed time or total count data. For a more detailed understanding of the system of the Patent, reference should be made to the Patent itself.

It will be understood that, while the embodiments described in the Patent are entirely satisfactory for use in situations requiring a high degree of resolution and accuracy, they can be difficult to use by a relatively unskilled technician making isolated field measurements and in other situations in which it would be desirable to read stored data with reasonable resolution and accuracy and to be able to do so easily and without the use of specialized instruments.

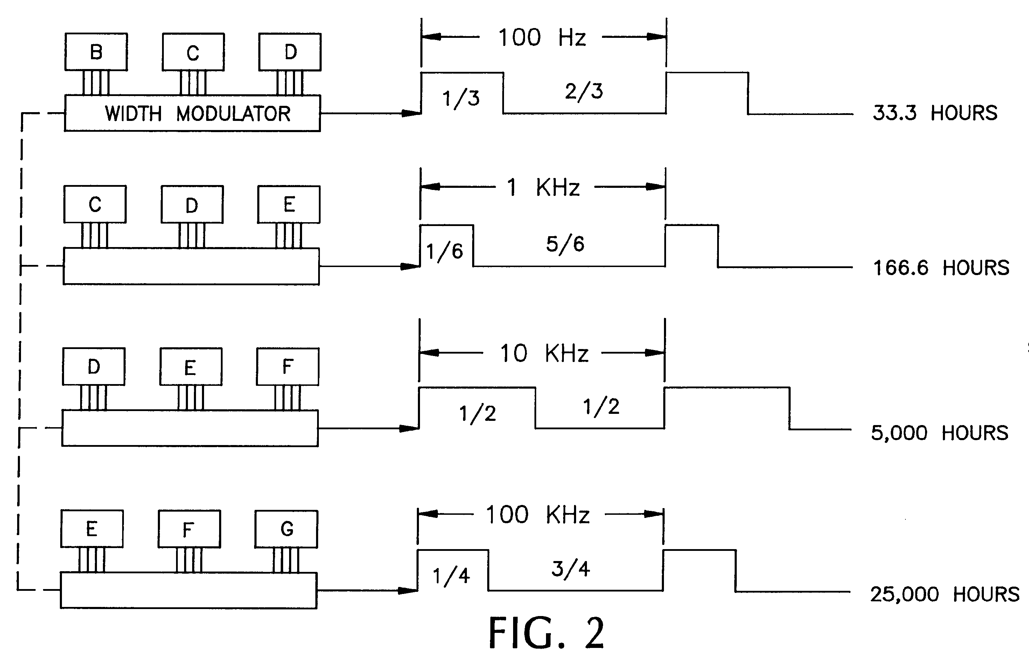

Reference now to Figure 2 will indicated how the data collected and stored in the system of the Patent can be configured so that it may be read by a conventional digital multimeter (DMM). Assume that the data under consideration is a measurement of total operating time and that circuits indicated by B-G on Figure 2 are digital divide-by-ten circuits in a volatile memory register such as volatile memory register 26 of Figure 1. Here, rather than outputing data through a serial bit encoder, the data is outputed through a pulse width modulator and the frequency of the modulator is set to indicate which of the divider circuits are involved in the encodement, in this case which groups of three are involved, although groups of any number could be involved. For the example shown, circuit B represents tenths, circuit C represents ones, and so forth, up to circuit G which represents ten thousands.

The above arrangement facilitates the readout of data by a DMM. For example, in the top data waveform on Figure 2, the frequency of the output is 100 Hz., thus indicating, in this case, that the full scale reading is 100 hours. The output waveform is pulse width modulated so that the waveform is positive for one-third of a cycle. Now, the person taking the data measurement has only to first use the DMM to measure frequency, observe that the measurement is 100 Hz. (i.e., full scale is 100 hours), then use the DMM function to measure duty cycle and read 33.3% (i.e., 33.3 hours elapsed time). Likewise, if the total elapsed time accumulates to over 10,000 hours (bottom line of Figure 2), the frequency reading would be 100 KHz. and (for the example shown) the duty cycle reading is 25.00%, or 25,000 hours total elapsed time. It will be understood that the above ranges have been given for example only and that 1 Hz. does not necessarily have to represent 1 hour.

A DMM useful in practicing the present invention may be one of the Fluke 80 series multimeters and is preferably the Fluke 87 multimeter, as furnished by John Fluke Manufacturing Company, Inc., Everett, Washington. The Fluke 87 multimeter has 0.1% DC accuracy, a 4-1/2-digit readout, and measures frequency and average and peak voltages, among other features. A duty cycle function provides a percentage readout from pulse width modulated inputs. Average voltage reading can be substituted for duty cycle if the level of peak voltage is taken into account, and, for purposes of this disclosure and the claims appended hereto, such substitution is considered the equivalent of duty cycle.

A particular advantage of using such a meter as the data receiving and display instrument is that the meter is likely to be a standard item in the technician's tool box and no specialized instrument is required. The meter is designed to be compact and rugged for use in the field, as opposed to more sensitive, laboratory-type instruments. The meter is also economical to purchase and simple to use. All that is required is for the technician to attach two leads to output connections on the piece of equipment to be analyzed. The simple sequential procedure for taking the measurements may be included in the service manual and/or it may simply be printed on a label near the output connections on the equipment. No specialized knowledge is required, as the technician is reading data measurements with which he is familiar from other uses of the meter.

With the decade arrangement shown on Figure 2, the system starts, for example, with a 100-hour range and when 100 hours is exceed, the range automatically switches to 1000 hours. Then when 1000 hours is exceeded, the range automatically switches to 10,000 hours. For example, when the total time is 99 hours, the reading will be 99% in the 100-hour range and when the total time goes to 101 hours, the reading will be 10.1% in the 1000-hour range. Thus, when the total time is more than 9 hours, there will always be two digits before the decimal point. This arrangement assures that the 0.1% accuracy of the DMM does not become critical to the measurement.

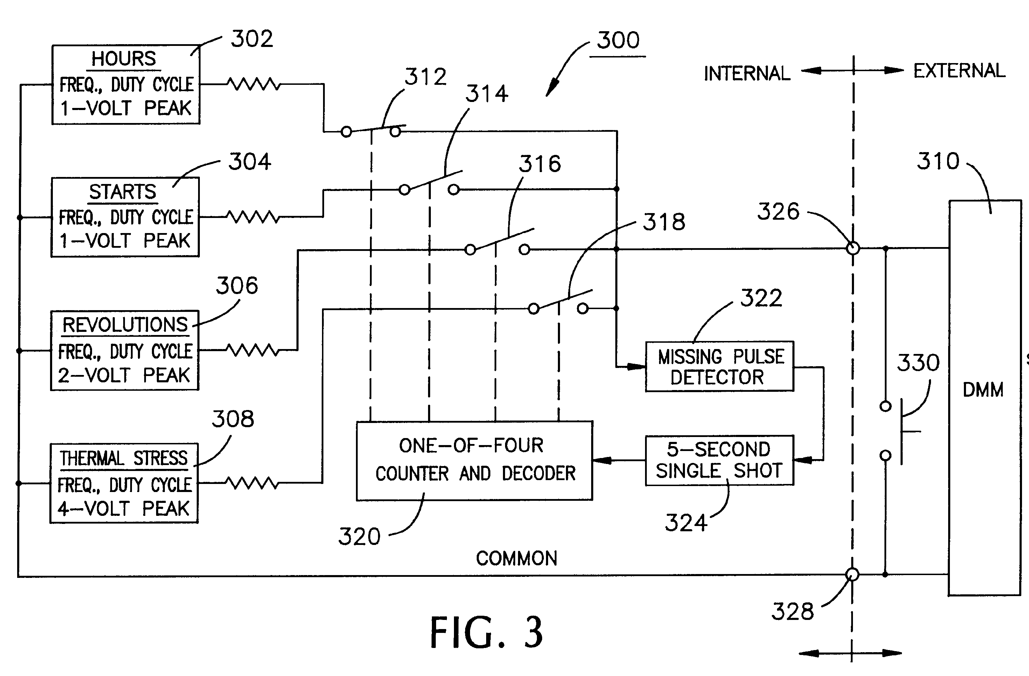

To further expand the usefulness of the DMM in situations in which several channels of data may be transmitted over the same transmission line or through the same output connections on a machine, it is desirable to involve three variables: frequency, duty cycle, and amplitude (peak voltage). Figure 3 shows an embodiment of the present invention comprising a data reading system, generally indicated by the reference numeral 300, which may be used to read such several channels of data, here, for purposes of example only, total elapsed time, number of starts, total revolutions, and thermal stress. Such parameters might be of interest in monitoring performance of a tractor having an internal combustion engine.

System 300 includes data transmitters 302, 304, 306, and 308 which may be assumed to include, for example, cumulative operations measurement systems according to the teachings of above-referenced US Patent No. 4,712,195, with output data encoded with pulse width modulators according to Figure 2 hereof. Data transmitters 302, 304, 306, and 308 of system 300 are connected to provide an input signal to DMM 310 through, respectively, switches 312, 314, 316, and 318, the switches operable by a one-of-four counter and decoder 320, such that only one of the four switches is connected to provide an input to the DMM at any one time. The input to DMM 310 is also an input to a missing pulse detector 322 which initiates a 5-second (arbitrary interval) single-shot circuit 324 which, in turn, causes one-of-four counter and decoder 320 to increment. System 300 may be internal to the machine being tested, as indicated on Figure 3 and may be accessible to external measurement through connections 326 and 328 which may be jacks for leads from DMM 310. Disposed across the inputs to DMM 310 is a momentary contact switch 330 which shorts the inputs.

In the embodiment of Figure 3, the three variables of frequency, duty cycle, and amplitude encode the data as follows: frequency and duty cycle represent full scale and percent of full scale, respectively, as described with reference to Figure 2, and peak voltage serves as an identifier to indicate which parameter is being read. For example, in operation, the technician connects DMM 310 to connections 326 and 328, sets the DMM to read peak voltage, then depresses switch 330 for a given minimum period of time. Missing pulse detector 322 then senses the absence of a signal which activates 5-second single-shot circuit 324 to cause counter 320 to increment and close the next switch, in this case switch 312. DMM 310 will read 1 volt, thus indicating that the parameter being read is total elapsed time. The technician then sets the DMM 310 to read frequency to read the full-scale range, and then sets the DMM to read duty cycle to read percent of full-scale. The technician then again presses switch 330, again shorting the input to DMM 310 and the cycle is repeated for the next parameter, in this case the total number of starts. Other parameters will be sequentially read in a like manner. It will be understood that the reading sequence may not necessarily start with the closing of switch 310, but whatever switch is closed first, the parameter being read will be immediately identifiable by the technician by reading the peak voltage and referring to a chart in the service manual or on a label near output connections 326 and 328.

It will be understood that switch 330 must be depressed some minimum amount of time. For example, if the lowest transmission frequency is, say, 10 Hz., switch 330 would have to be depressed a minimum of 0.1 second to guarantee "killing" at least one transmission cycle. Alternatively, a small, fixed offset could be applied which when shorted would produce an instant response.

The external momentary contact switch, although convenient, is not mandatory, as the technician can simply short the data input by taking the jack from the voltage input and inserting it into the current input for the required time, since the current input is shunted to the common input, and then reinserting the jack into the voltage input to read the function identifier. This latter procedure is especially useful with the above-identified DMM, since the shorting of the inputs is accompanied by an audible signal.

It will be understood that the frequency, duty cycle, and peak voltage can be reassigned in any desired manner within the intent of the present invention. For example, duty cycle could be assigned as a range identifier; so, for example, a reading of 10% could indicate a maximum range of 100 hours, 20% a maximum range of 1000 hours, and so forth. Then, for example, frequency could be assigned to indicate the value of the parameter, such as each 10-Hz. increment equaling 1 hour.

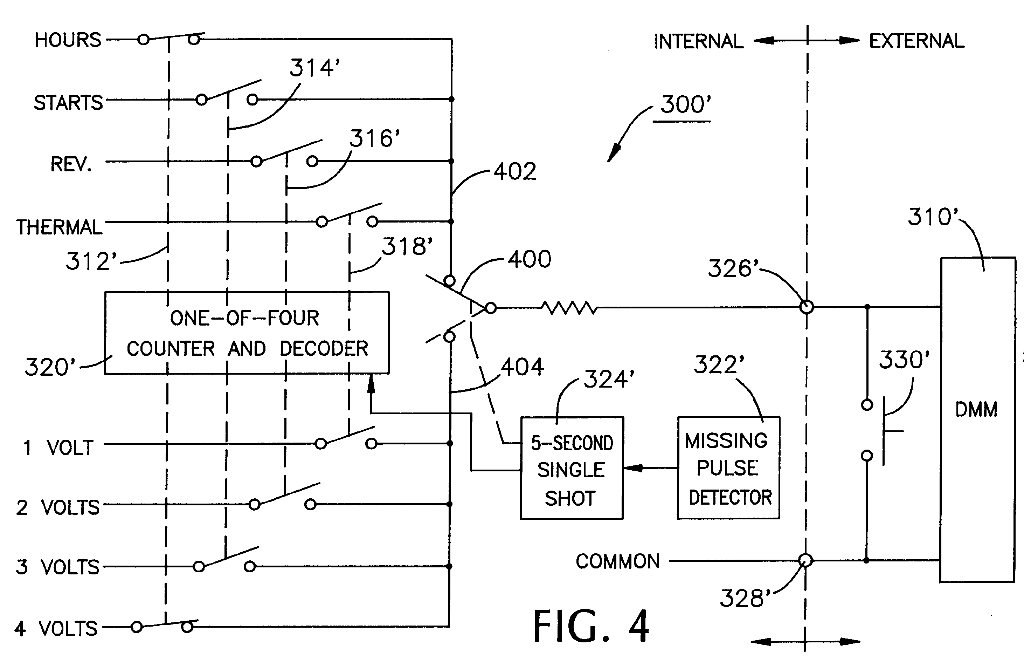

Figure 4 shows a modification of system 300 of Figure 3, here the identifying numerals for components similar to those shown on Figure 3 are given primed reference numerals. System 300′ is especially useful where the output from any channel produces a valid output pulse width which is too narrow for reliable peak reading. This limitation is overcome with system 300′ by means of providing compound switches 310′, 312′, 314′, and 316′ which provide an initial sustained voltage identifier which can be easily read in one of the voltage reading modes. In operation, switch 330′ is closed for, say, 0.25 to 2 seconds, activating missing pulse detector 322′ which immediately increments the one-of-four counter and decoder 320′ and also switches a switch 400 from a data output line 402 (solid position of switch 400) to a voltage identifier line 404 (dashed position of switch 400). As soon as switch 330′ is released, 4 volts will appear on the readout of DMM 310′ and will remain there until the end of the 5-second interval when switch 400 is switched to data output line 402 (solid position of switch 400). If the time after the opening of switch 330′ is to be constant, system 300′ can be further enhanced by including an auxiliary "off delay" (not shown) to sustain the identifier for a precise interval of time, e.g. three seconds.

Again, the invention is not limited to the arrangement of the parameters described with respect to the embodiments of Figures 3 and 4, but may be any desired arrangement of the parameters. Also, it is not necessary that the variables be read in any particular order; although, some orders of reading may be more convenient than others.

A potential problem with the present invention as described above may exist when a new system is being put on line and there is no data in memory. This problem can be overcome by introducing into the data chain a short spike which will guarantee that there will be a rising voltage edge. For example, assume that the first data transmission will occur at 10 Hz. With the 0.1% accuracy of the DMM, the smallest value that could be read would be 100 microseconds. Therefore, one can introduce, say, a 1 microsecond false pulse which the DMM will still read as zero, since that value is only 1% of the smallest that can be read, but the DMM will be able to pick up a frequency. Alternatively, the memory counter could be pre-loaded with a fixed value and the technician instructed to subtract that value from the first reading.

While, as noted above, any arrangement of parameters may be employed with the present invention, certain parameters are better suited than others for certain purposes. For example, frequency can be read with a DMM with great resolution and, therefore, as further described below, a large amount of information may be encoded in a frequency signal. Voltage, on the other hand, being produced and read in an analog mode would not normally be used where high resolution is required and is well suited to use as an identifier as in the embodiment shown on Figure 4 or in other cases where fairly large increments are satisfactory.

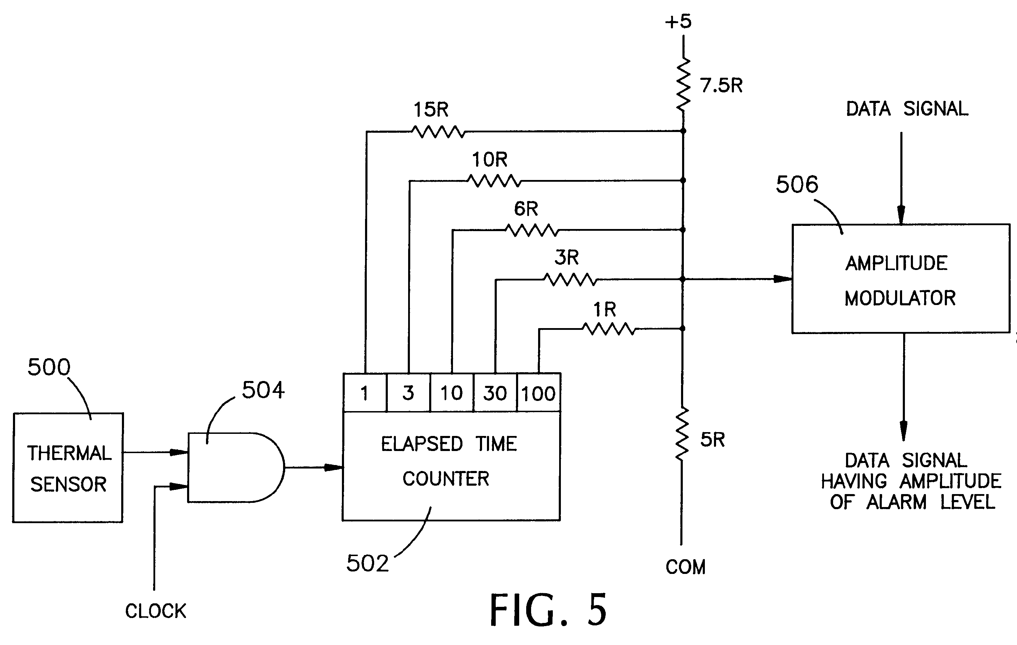

An example of another use to which voltage measurement may be advantageously employed is illustrated on Figure 5, where the amplitude of the data signal is modulated to serve as an alarm signal, here, for illustrative purposes only, as an indicator of the total time a piece of equipment has been in an overtemperature condition. This is a situation where, typically, great accuracy in knowing the precise total time is not required, but it is desirable to have an indication of a fairly broad interval of time the equipment has been in an overtemperature condition. Referring to Figure 5, a signal from an overtemperature sensor 500 is gated to an elapsed time counter 502 through an AND gate 504 by a clock signal. The outputs from elapsed time counter 502 have been arbitrarily set for ranges of up to 1 hour, 1 to 3 hours, 3 to 10 hours, 10 to 30 hours, and 30 to 100 hours. With the values of the resistors indicated, the voltage from counter 502 will be 2 volts when there is no signal from the counter, 2.5 volts when up to 1 hour, 3.0 volts when 1 to 3 hours, 3.5 volts when 3 to 10 hours, 4.0 volts when 10 to 30 hours, and 4.5 volts when 30 to 100 hours. Thus, the voltage intervals are large steps and well within the resolution of a DMM. The voltage signal from counter 502 is an input to amplitude modulator 506 which transmits the data signal at the amplitude determined by the voltage level from the counter. When applied to the embodiment of Figure 4, for example, amplitude modulator 506 would be placed in data output line 402.

It will be noted that no provision has been made in the embodiments of Figures 3 and 4 to provide for resetting memories of the measurement system or supplying power to the measurement system when it is not operating, both of which functions are included in the readers of US Patent No. 4,712,195 and US Application Serial No. 07/071,801. While these functions may be provided for in conjunction with the present invention, they have not been shown with those embodiments, since, in the applications for which the invention is primarily expected to be used, the technician would not normally be resetting the memories and the power to the machine or other apparatus would normally be on.

When reset is desired, however, convenient shorting of the inputs to a DMM offers an easily employed scheme for resetting one or more data channels and one which may be coded to prevent unintentional or unpermitted resetting. In its basic aspect, the inputs of the DMM are shorted for a specified time. At the end of that time, if data signals resume, the reset circuit recognizes that a deliberate reset signal was sent and a data channel or all data channels are reset. It is desirable that a sufficiently long shorting time be required so that routine use of the instrument in data reading would not accidentally cause resetting. For example, a short-circuit interval of 27 seconds might be chosen, which is probably an order of magnitude longer than the inputs to the DMM would be shorted during normal data reading. Then, if data signals resume within a short period of time, say, 1 second, the reset circuit would recognize a reset signal was being transmitted and the data channel(s) would be reset.

The table below indicates an exemplary scheme with which a selected one of four data channels or all data channels can be reset using coded signals comprising selected series of timed short- and open-circuits:

| ACCESS CODE (SECONDS) | | | FUNCTION |
|---|---|---|---|
| Short | Open | Short | |
| 12 | 3 | 17 | Reset all channels |
| 9 | 6 | 8 | Reset channel 1 |
| 10 | 4 | 5 | Reset channel 2 |
| 7 | 7 | 11 | Reset channel 3 |
| 5 | 9 | 7 | Reset channel 4 |

For example, when the reset circuit detects a short-circuit of 12 seconds followed by 3 seconds of open-circuit, and then 17 seconds of short-circuit followed by an open-circuit condition, it will reset all channels. It will be understood that the short-circuit inputs may be caused by shorting the inputs to a DMM, as described above with reference to Figures 3 and 4, but the present invention is not necessarily so limited.

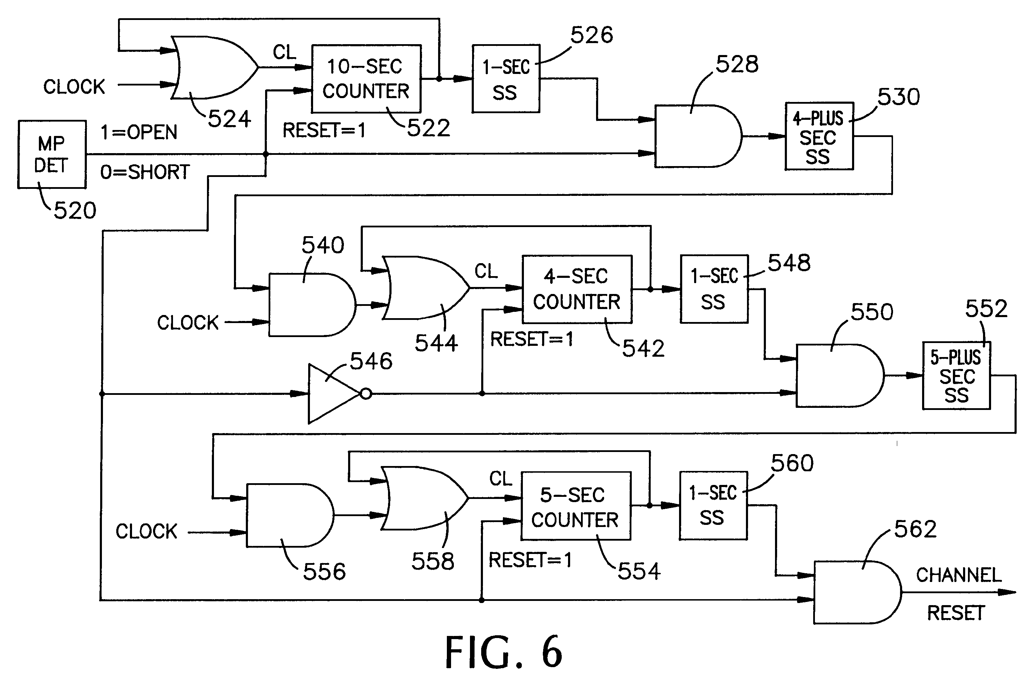

Figure 6 illustrates the configuration of a reset circuit for resetting channel 2 according to the 10-short/4-open/5-short scheme set forth in the above table. There is included a device for selectively providing logical "1" or logical "0" signals, which may be, for example only, a missing pulse detector 520 connected to the data reading systems of Figures 3 or 4. Missing pulse detector 520 detects a missing pulse and provides a logical "0" output to 10-second counter 522 which allows the counter to count clock pulses provided through OR gate 524. If pulses resume during the 10-second interval, missing pulse detector 520 will provide a logical "1" output to counter 522 which will reset the counter. If, however, the short-circuit continues for at least 10 seconds, counter 522 fires a 1-second single-shot circuit 526 and stops counting via the "lock-up" feedback to OR gate 524, the single-shot providing a logical "1" to AND gate 528. If during the 1-second interval, missing pulse detector 520 detects an open-circuit condition and provides a logical "1" output to AND gate 528, the AND gate will fire 4-plus-second single-shot 530. If, however, there is no open-circuit condition during the 1-second interval, 4-plus-second single-shot 530 will not be fired.

Assuming that the reset sequence is proceeding as set forth in the above table, 4-plus-second single-shot 530 provides a logical "1" input to AND gate 540 which provides a clock signal to 4-second counter 542 through OR gate 544. At this point, missing pulse detector 520 has detected an open condition and provides a logical "1" output, inverter 546 thereby providing a logical "0" to the reset input of counter 542, allowing the counter to count. At the end of the 4-second interval, 4-second counter 542 fires 1-second single-shot 548 which provides a logical "1" output to AND gate 550. If, now, a short-circuit condition is detected by missing pulse detector 520, a logical "1" will be produced at the output of inverter 546 and a 5-plus-second single-shot 552 will be fired by AND gate 550.

In like manner as the first two loops, 5-plus-second single-shot 552 causes a clock signal to be provided to 5-second counter 554 through AND gate 556 and OR gate 558, with 1-second single-shot 560 providing a logical "1" input to AND gate 562. Providing that the reset sequence has proceeded properly, AND gate 562 will now receive a logical "1" input from missing pulse detector 520 and will provide an output reset signal, which signal may be provided, for example, to master reset 91 of Figure 1.

It will be understood that, for example, 4-plus-second single-shot 530 must introduce a delay which is sufficiently longer than 4-second counter 542 to allow for clock digitization, less-than-perfect timing on the part of the technician, and the like.

As noted above, parameters, such as frequency, which can be read with high resolution may be employed to encode a great deal of information. For example, frequency may be used to encode a site, a data channel, and a range. This can be accomplished, for illustrative purposes only, by letting the tens digit represent a site, the units digit represent a channel, and the tenths digit represent a range. With this scheme, a reading of 32.4 KHz would identify the data as originating at site 3, channel 2, and the range is whatever has been assigned as range 4.

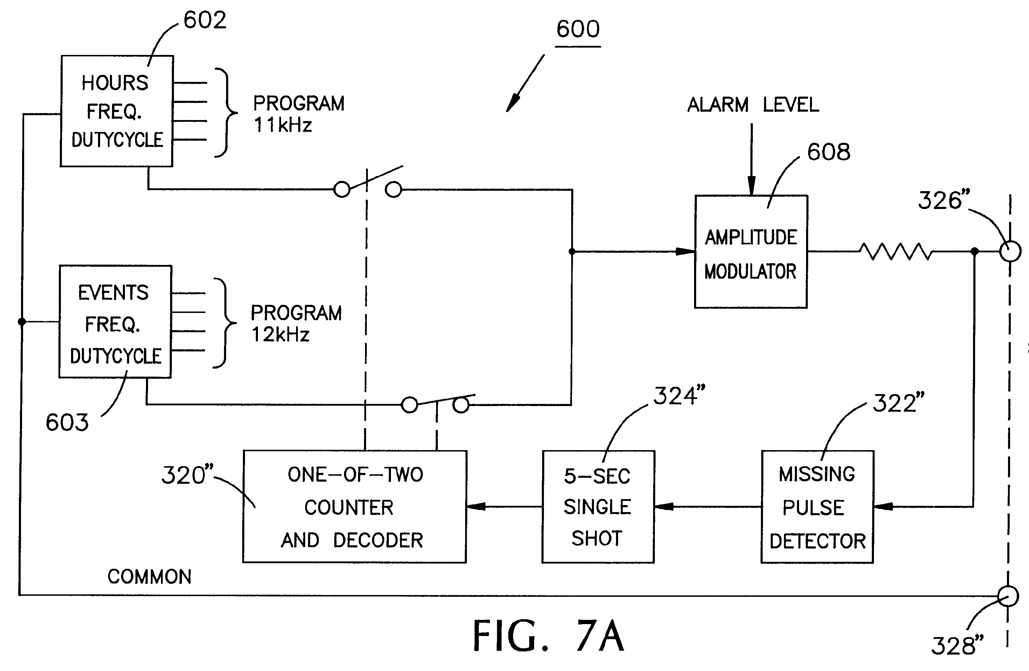

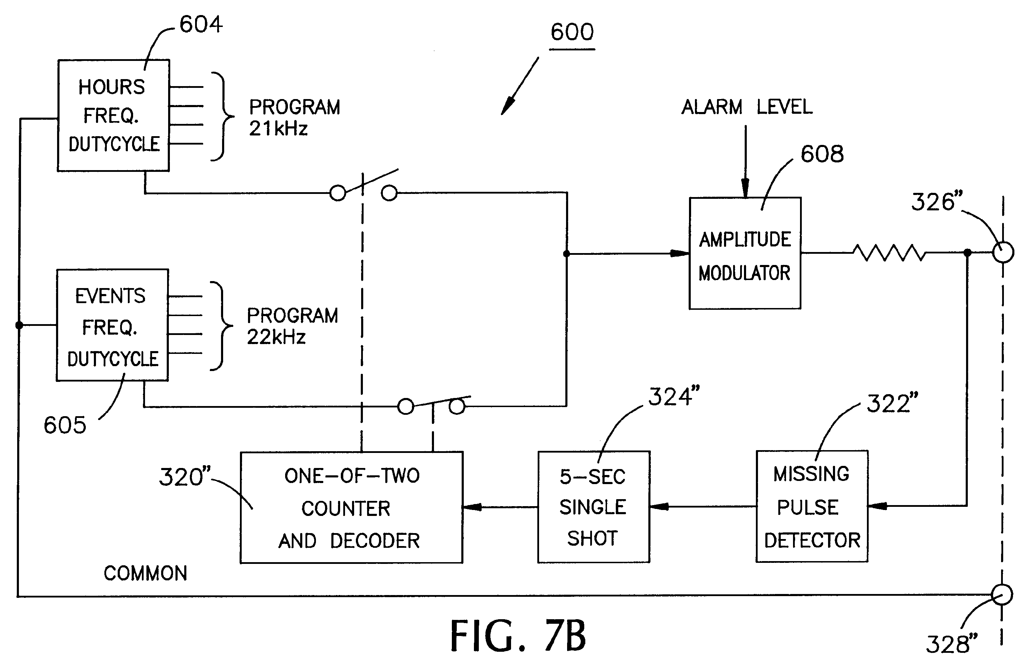

Figures 7A and 7B illustrate another embodiment of the present invention in which one variable, for example in this case, frequency, is encoded with multiple information and the data is read with a data reading system 600 which includes data terminals 602-605, one-of-two counter and decoder 320", missing pulse detector 322", 5-second single-shot 324", and DMM connections 326" and 328" (DMM not shown), all having the same functions as described for similar elements on Figures 3 and 4. Also included is amplitude modulator 608 which has the same function as amplitude modulator 506 on Figure 5. Here, Figure 7A represents the situation where data transmitters 602 and 603 are at site "1" and Figure 7B the situation where data transmitters 604 and 605 are at site "2".

Referring to Figure 7A, data transmitter 602, which contains data representing elapsed time, for example, has been programmed so that the output thereof has a baseline frequency of 11 KHz, with the tens digit representing site "1" and the units digit representing channel "1". The range of the hours data is determined by the tenths digit, which may be raised by 100 Hz for each uprange. Likewise, on Figure 7B, data transmitter 605, which represents total number of events, is programmed with a baseline frequency of 22 KHz, indicating that the data therefrom originates from site "2" and channel "2". In either case, percent of range would be read as duty cycle. Thus, even when data is received by a technician from multiple data sites and multiple channels at each site, the source of the data is uniquely identified. It will be understood that many orders of magnitude of unique combinations are available, each one being uniquely identified and easily readable by a DMM.

All functions of the systems of the present invention can be handled by a dedicated apparatus, but, most conveniently, the functions may be handled by a programmable microprocessor already part of the machine being analyzed and which microprocessor has other, primary purposes.

It will be understood that, while the present invention has been described as being particularly applicable to the reading of data in the field, it may be used as well in other settings and may be used in situations in which the readings are not taken directly from the machine being analyzed, but may be taken from data transmitted over a distance by any of various means known in the art.

## Claims

1.  A method of processing and reading a single data signal having a plurality of variables and representing the value of a parameter, comprising:

    (a) electronically encoding the single data signal with a first variable indicating full-scale range of the said value;

    (b) electronically encoding the single data signal with a second variable indicating the magnitude of the said value;

    (c) reading the first variable in the single data signal to determine the full-scale range; and

    (d) reading the second variable in the single data signal to determine the said value.

2.  A method according to claim 1, further including the steps of:

    (e) electronically encoding the single data signal with a third variable indicating the said parameter the data represents; and

    (f) reading the third variable in the single data signal to determine the said parameter the data represents.

3.  A method according to claim 1, characterised in that the first and second variables are selected from the group consisting of frequency, peak voltage, and duty cycle.

4.  A method according to any preceding claim, characterised in that the variables are read with a digital multimeter.

5.  A method according to claim 1, wherein at least one additional single data signal having another value and representing another parameter is read, the at least one additional single data signal being electronically encoded with a first variable indicating full-scale range of the value and being electronically encoded with a second variable indicating the magnitude of the value the method further comprising:

    (a) encoding each one of the single data signals with a third variable uniquely identifying the parameter;

    (b) sequentially selecting one of the encoded single data signals;

    (c) using a digital multimeter to read the third variable indicating the parameter;

    (d) using the digital multimeter to read the first variable indicating the full-scale range; and

    (e) using the digital multimeter to read the second variable indicating the magnitude of the said value of the parameter.

6.  A method according to claim 1, wherein at least one additional single data signal having another value and representing another parameter is read, the at least one additional single data signal being electronically encoded with a first variable indicating full-scale range of the value and being electronically encoded with a second variable indicating the magnitude of the value, the method further comprising:

    (a) providing each single data signal with a third variable uniquely indicating the identity of the parameter;

    (b) sequentially selecting one of the encoded single data signals;

    (c) using a digital multimeter to read the third variable indicating the identity of the parameter;

    (d) using the digital multimeter to read the first variable to indicate the full-scale range of the said value; and

    (e) using the digital multimeter to read the second variable to indicate the magnitude of the said value.

7.  A method according to any of claims 2, 5 and 6, characterised in that the variables are two or more variables selected from the group consisting of frequency, peak voltage, and duty cycle.

8.  A method according to claim 3 or claim 7, further comprising encoding the said single data signal with a variable indicating an alarm level.

9.  Apparatus for processing and reading a first single data signal having a plurality of variables and representing the value of a parameter, comprising:

    (a) means (302, 304, 306, 308) for electronically encoding the first single data signal with a first variable indicating full-scale range of the said first value;

    (b) means (302, 304, 306, 308) for electronically encoding the first single data signal with a second variable indicating the magnitude of the said first data signal;

    (c) means (310, 312, 314, 316, 320, 322, 324, 600) for reading the first variable in the first single data signal to determine the full-scale range; and

(d) means (310, 312, 314, 316, 320, 322, 324, 600) for reading the second variable in the first single data signal to determine the value of the data.

10. Apparatus according to claim 9, further comprising:

(e) means (302, 304, 306, 308) for electronically encoding the single data signal with a third variable indicating the parameter the data represents; and

(f) means (310) for reading the third variable in the single data signal to determine the parameter the data represents.

11. Apparatus according to claim 9, characterised in that the first and second variables are selected from the group consisting of frequency, peak voltage, and duty cycle.

12. Apparatus according to claim 10, characterised in that the variables are two or more variables selected from the group consisting of frequency, peak voltage, and duty cycle.

13. Apparatus according to any of claims 9 to 12, characterised in that the means (310) for reading comprises a digital multimeter.

14. Apparatus according to claim 12, further comprising:

(a) means (502, 504, 506, 608) for electronically encoding the single data signal with a variable selected from the group indicating an alarm condition; and

(b) means (310) for reading the said variable in the single data signal to determine if the alarm condition exists.

15. Apparatus according to claim 9, wherein at least a second single data signal having another value and representing another parameter is processed and read, the apparatus further comprising:

(a) a plurality of encoding means (302, 304, 306, 308) each one for connection to one of a plurality of devices each one containing one of the first and at least a second single data signals indicating the value of one of the parameters, each of the encoding means to receive and encode one of the first and at least a second single data signals with a first variable uniquely indicating the full-scale range of the said value, to encode the one of said first and at least a second data signals with a second variable uniquely indicating the parameter represented by the first variable, and to encode the one of said first and at least a second data signals with a third variable the magnitude of which indicates the magnitude of the said value of the said parameter;

(b) connection means (326, 326′, 326″) to connect the apparatus to the inputs of a digital multimeter;

(c) means (330) to short-circuit the connection means a selected length of time during which no signal can be detected across the connection means;

(d) counter and decoder means (320, 320′, 320″) to select sequentially one of the encoding means to provide one of the first and at least a second single data signals to the connection means;

(e) missing pulse means (322, 322′, 322″) to detect when the connection means is shorted; and

(f) single shot circuit means (324, 324′, 324″) responsive to the missing pulse means to cause the counter and decoder means to increment when the connection means is short-circuited.

16. Apparatus according to claim 9, wherein at least a second single data signal having another value and representing another parameter is processed and read, the apparatus further comprising:

(a) a plurality of encoding means (302, 304, 306, 308) each one for connection to one of a plurality of devices each one containing one of the first and at least a second single data signals indicating the value of one of the parameters, each of the encoding means to encode one of the first and at least a second single data signals with a first variable uniquely indicating the full-scale range of the said value and to encode the one of said first and at least a second data signals with a second variable the magnitude of which second variable indicates the magnitude of the said value of the said parameter;

(b) means (302, 304, 306, 308) to provide for each parameter an identifying third variable indicating the identity of the parameter;

(c) connection means (326, 326′, 326″) to connect the apparatus to the inputs of a digital multimeter;

(d) means (330) to short-circuit the connection means a selected length of time during which no signal can be detected across the connection means;

(e) counter and decoder means (320, 320′, 320″) to select sequentially one of the encoding means to provide one of the first and at least a second single data signals to the connection means;

(f) switch means (312, 314, 316, 318, 312′, 314′, 316′, 318′) to provide selectively to the connection means either one of the single data signals or the said identifying variable unique to the said one of the first and at least a second single data signals;

(g) missing pulse means (322, 322′, 322″) to detect when the connection means is shorted; and

(h) single shot circuit means (324, 324′, 324″) responsive to the missing pulse means to cause the counter and decoder means to increment when the connection means is shorted, to cause the switch means to provide to the connection means the identifying third variable unique to the said one of the first and at least a second single data signals for a selected interval of time, then to cause the switch means to provide to the connection means the first variable indicating the full-scale range of the said value.

17. Apparatus according to claim 15 or claim 16, further comprising:

(a) reset circuit means (Fig. 6) connected to at least one of the said plurality of devices for resetting thereof, the circuit means having input means (520) to provide selectively logical "1" or logical "0" inputs, a selected output from which reset circuit means causes the said at least one of the plurality of devices to reset; and

(b) the input means (520) to selectively provide either a logical "1" input or a logical "0" input for a first selected period of time, at the end of which period, the reset circuit means provides the selected output.

18. Apparatus according to claim 17, characterised in that the reset circuit means provides the selected output only after termination of the other of the said logical "1" or "0" inputs for a second selected period of time following the first selected period of time.

19. Apparatus according to claim 15 or claim 16, characterised in that the variables are two or more variables selected from the group consisting of frequency, peak voltage, and duty cycle.

20. Apparatus according to claim 19, further comprising means (500, 502, 504, 506) to encode the said single data signal with a variable indicating an alarm level.


## Patentansprüche

1. Verfahren zum Verarbeiten und Lesen eines einzelnen Datensignals, welches eine Vielzahl von Variablen aufweist und den Wert eines Parameters darstellt, umfassend:

(a) elektronisches Kodieren des einzelnen Datensignals mit einer ersten, den Skalenbereichsendwert des Wertes angebenden Variablen,

(b) elektronisches Kodieren des einzelnen Datensignals mit einer zweiten, die Größe des Wertes angebenden Variablen,

(c) Lesen der ersten Variablen in dem einzelnen Datensignal, um den Skalenbereichsendwert zu ermitteln, und

(d) Lesen der zweiten Variablen in dem einzelnen Datensignal, um den Wert zu ermitteln.

2. Verfahren nach Anspruch 1, weiter umfassend die Schritte:

(e) elektronisches Kodieren des einzelnen Datensignals mit einer dritten, den Parameter, den das Datenmaterial darstellt, angebenden Variablen und

(f) Lesen der dritten Variablen in dem einzelnen Datensignal, um den Parameter, den das Datenmaterial darstellt, zu ermitteln.

3. Verfahren nach Anspruch 1, dadurch gekennzeichnet, daß die ersten und zweiten Variablen aus der Gruppe ausgewählt sind, die aus Frequenz, Spitzenspannung und Arbeitszyklus besteht.

4. Verfahren nach einem der vorhergehenden Ansprüche, dadurch gekennzeichnet, daß die Variablen mit einem digitalen Vielfachmeßgerät gelesen werden.

5. Verfahren nach Anspruch 1, worin zumindest ein zusätzliches einzelnes Datensignal, das einen anderen Wert hat und einen anderen Parameter darstellt, gelesen wird, wobei das zumindest eine zusätzliche einzelne Datensignal mit einer ersten, den Skalenbereichsendwert des Wertes angebenden Variablen elektronisch kodiert wird und mit einer zweiten, die Größe des Wertes angebenden Variablen elektronisch kodiert wird und wobei das Verfahren weiter umfaßt:

(a) Kodieren jedes einzelnen der einzelnen Datensignale mit einer dritten, den Parameter eindeutig kennzeichnenden Variablen,

(b) sequentielles Auswählen eines der kodierten einzelnen Datensignale,

(c) Verwenden eines digitalen Vielfachmeßgeräts zum Lesen der dritten, den Parameter angebenden Variablen,

(d) Verwenden des digitalen Vielfachmeßgeräts zum Lesen der ersten, den Skalenbereichsendwert angebenden Variablen und

(e) Verwenden des digitalen Vielfachmeßgeräts zum Lesen der zweiten, die Größe des Wertes des Parameters angebenden Variablen.

6. Verfahren nach Anspruch 1, worin zumindest ein zusätzliches einzelnes Datensignal, das einen anderen Wert hat und einen anderen Parameter darstellt, gelesen wird, wobei das zumindest eine zusätzliche einzelne Datensignal mit einer ersten, den Skalenbereichsendwert des Wertes angebenden Variablen elektronisch kodiert wird und mit einer zweiten, die Größe des Wertes angebenden Variablen elektronisch kodiert wird und wobei das Verfahren weiter umfaßt:

(a) Versehen jedes einzelnen Datensignals mit einer dritten, die Identität des Parameters eindeutig angebenden Variablen,

(b) sequentielles Auswählen eines der kodierten einzelnen Datensignale,

(c) Verwenden eines digitalen Vielfachmeßgeräts zum Lesen der dritten, die Identität des Parameters angebenden Variablen,

(d) Verwenden des digitalen Vielfachmeßgeräts zum Lesen der ersten Variablen, um den Skalenbereichsendwert des Wertes anzugeben, und

(e) Verwenden des digitalen Vielfachmeßgeräts zum Lesen der zweiten Variablen, um die Größe des Wertes anzugeben.

7. Verfahren nach einem der Ansprüche 2, 5 oder 6, dadurch gekennzeichnet, daß die Variablen zwei oder mehrere aus der Gruppe ausgewählte Variablen sind, die aus Frequenz, Spitzenspannung und Arbeitszyklus besteht.

8. Verfahren nach Anspruch 3 oder 7, weiter umfassend das Kodieren des einzelnen Datensignals mit einer einen Alarmpegel angebenden Variablen.

9. Vorrichtung zum Verarbeiten und Lesen eines ersten einzelnen Datensignals, welches eine Vielzahl von Variablen aufweist und den Wert eines Parameters darstellt, umfassend:

(a) ein Mittel (302, 304, 306, 308) zum elektronischen Kodieren des ersten einzelnen Datensignals mit einer ersten, den Skalenbereichsendwert des ersten Wertes angebenden Variablen,

(b) ein Mittel (302, 304, 306, 308) zum elektronischen Kodieren des ersten einzelnen Datensignals mit einer zweiten, die Größe des ersten Datensignals angebenden Variablen,

(c) ein Mittel (310, 312, 314, 316, 320, 322, 324, 600) zum Lesen der ersten Variablen in dem ersten einzelnen Datensignal, um den Skalenbereichsendwert zu ermitteln, und

(d) ein Mittel (310, 312, 314, 316, 320, 322, 324, 600) zum Lesen der zweiten Variablen in dem ersten einzelnen Datensignal, um den Wert des Datenmaterials zu ermitteln.

10. Vorrichtung nach Anspruch 9, weiter umfassend:

(e) ein Mittel (302, 304, 306, 308) zum elektronischen Kodieren des einzelnen Datensignals mit einer dritten, den Parameter, den das Datenmaterial darstellt, angebenden Variablen und

(f) ein Mittel (310) zum Lesen der dritten Variablen in dem einzelnen Datensignal, um den Parameter, den das Datenmaterial darstellt, zu ermitteln.

11. Vorrichtung nach Anspruch 9, dadurch gekennzeichnet, daß die ersten und zweiten Variablen aus der Gruppe ausgewählt sind, die aus Frequenz, Spitzenspannung und Arbeitszyklus besteht.

12. Vorrichtung nach Anspruch 10, dadurch gekennzeichnet, daß die Variablen zwei oder mehrere aus der Gruppe ausgewählte Variablen sind, die aus Frequenz, Spitzenspannung und Arbeitszyklus besteht.

13. Vorrichtung nach einem der Ansprüche 9 bis 12, dadurch gekennzeichnet, daß das Mittel (310) zum Lesen ein digitales Vielfachmeßgerät umfaßt.

14. Vorrichtung nach Anspruch 12, weiter umfassend:

(a) ein Mittel (502, 504, 506, 608) zum elektronischen Kodieren des einzelnen Datensignals mit einer Variablen, die aus der Gruppe ausgewählt ist, die eine Alarmbedingung angibt, und
(b) ein Mittel (310) zum Lesen der Variablen in dem einzelnen Datensignal, um zu ermitteln, ob die Alarmbedingung vorliegt.

15. Vorrichtung nach Anspruch 9, worin zumindest ein zweites einzelnes Datensignal, das einen anderen Wert hat und einen anderen Parameter darstellt, verarbeitet und gelesen wird und wobei die Vorrichtung weiter umfaßt:
(a) eine Vielzahl von Kodiermitteln (302, 304, 306, 308), wobei jedes zum Anschluß an eine von einer Vielzahl von Vorrichtungen ausgebildet ist, die jede das erste oder zumindest ein zweites einzelnes Datensignal enthält, die den Wert eines der Parameter angeben, und wobei jedes der Kodiermittel zum Empfangen und Kodieren des ersten oder zumindest eines zweiten einzelnen Datensignals mit einer ersten, den Skalenbereichsendwert des Wertes eindeutig angebenden Variablen, zum Kodieren des ersten oder zumindest eines zweiten Datensignals mit einer zweiten, den durch die erste Variable dargestellten Parameter eindeutig angebenden Variablen und zum Kodieren des ersten oder zumindest eines zweiten Datensignals mit einer dritten Variablen ausgebildet ist, deren Größe die Größe des Wertes des Parameters angibt,
(b) ein Anschlußmittel (326, 326', 326'') zum Anschließen der Vorrichtung an die Eingänge eines digitalen Vielfachmeßgeräts,
(c) ein Mittel (330) zum Kurzschließen des Anschlußmittels für eine gewählte Zeitdauer, während derer kein Signal über das Anschlußmittel detektiert werden kann,
(d) ein Zähler- und Dekodierermittel (320, 320', 320'') zum sequentiellen Auswählen eines der Kodiermittel, um das erste oder zumindest ein zweites einzelnes Datensignal an dem Anschlußmittel bereitzustellen,
(e) ein Fehlimpulsmittel (322, 322', 322'') zum Detektieren, wann das Anschlußmittel kurzgeschlossen ist, und
(f) ein auf das Fehlimpulsmittel ansprechendes Einzelstromkreismittel (324, 324', 324'') zum Veranlassen des Zähler- und Dekodierermittels zu inkrementieren, wenn das Anschlußmittel kurzgeschlossen ist.

16. Vorrichtung nach Anspruch 9, worin zumindest ein zweites einzelnes Datensignal, das einen anderen Wert hat und einen anderen Parameter darstellt, verarbeitet und gelesen wird und wobei die Vorrichtung weiter umfaßt:
(a) eine Vielzahl von Kodiermitteln (302, 304, 306, 308), wobei jedes zum Anschluß an eine von einer Vielzahl von Vorrichtungen ausgebildet ist, die jede das erste oder zumindest ein zweites einzelnes Datensignal enthält, die den Wert eines der Parameter angeben, und wobei jedes der Kodiermittel zum Kodieren des ersten oder zumindest eines zweiten einzelnen Datensignals mit einer ersten, den Skalenbereichsendwert des Wertes eindeutig angebenden Variablen und zum Kodieren des ersten oder zumindest eines zweiten Datensignals mit einer zweiten Variablen ausgebildet ist, wobei die Größe der zweiten Variablen die Größe des Wertes des Parameters angibt,
(b) ein Mittel (302, 304, 306, 308) zum Bereitstellen einer kennzeichnenden dritten Variablen für jeden Parameter, welche die Identität des Parameters angibt,
(c) ein Anschlußmittel (326, 326', 326'') zum Anschließen der Vorrichtung an die Eingänge eines digitalen Vielfachmeßgeräts,
(d) ein Mittel (330) zum Kurzschließen des Anschlußmittels für eine gewählte Zeitdauer, während derer kein Signal über das Anschlußmittel detektiert werden kann,
(e) ein Zähler- und Dekodierermittel (320, 320', 320'') zum sequentiellen Auswählen eines der Kodiermittel, um das erste oder zumindest ein zweites einzelnes Datensignal an dem Anschlußmittel bereitzustellen,
(f) ein Schaltermittel (312, 314, 316, 318, 312', 314', 316', 318') zum selektiven Bereitstellen entweder eines der einzelnen Datensignale oder der kennzeichnenden Variablen, die eindeutig bezüglich des ersten oder zumindest eines zweiten einzelnen Datensignals ist, an dem Anschlußmittel,
(g) ein Fehlimpulsmittel (322, 322', 322'') zum Detektieren, wann das Anschlußmittel kurzgeschlossen ist, und
(h) ein auf das Fehlimpulsmittel ansprechendes Einzelstromkreismittel (324, 324', 324'') zum Veranlassen des Zähler- und Dekodierermittels zu inkrementieren, wenn das Anschlußmittel kurzgeschlossen ist, um das Schaltermittel zu veranlassen, die kennzeichnende dritte Variable, die eindeutig bezüglich des ersten oder zumindest eines zweiten einzelnen Datensignals ist, für ein gewähltes Zeitintervall an dem Anschlußmittel bereitzustellen, und um dann das Schaltermittel zu veranlassen, die erste, den Skalenbereichsendwert des Wertes angebende Variable an dem Anschlußmittel bereitzustellen.

17. Vorrichtung nach Anspruch 15 oder 16, weiter umfassend:

(a) ein Löschkreismittel (Fig. 6), das an zumindest eine der Vielzahl von Vorrichtungen zu deren Rückstellung angeschlossen ist, wobei das Kreismittel ein Eingangsmittel (520) zum selektiven Bereitstellen logischer "1"- oder logischer "0"-Eingangssignale aufweist und wobei ein ausgewähltes Ausgangssignal aus dem Löschkreismittel die zumindest eine der Vielzahl von Vorrichtungen zum Rückstellen veranlaßt, und

(b) ein derartiges Eingangsmittel (520), das selektiv entweder ein logisches "1"-Eingangssignal oder ein logisches "0"-Eingangssignal für eine erste gewählte Zeitdauer bereitstellt, wobei das Löschkreismittel das ausgewählte Ausgangssignal am Ende der Zeitdauer bereitstellt.

18. Vorrichtung nach Anspruch 17, dadurch gekennzeichnet, daß das Löschkreismittel das ausgewählte Ausgangssignal nur nach Beendigung des anderen der logischen "1"- oder 0"-Eingangssignale für eine zweite gewählte Zeitdauer bereitstellt, die der ersten gewählten Zeitdauer folgt.

19. Vorrichtung nach Anspruch 15 oder 16, dadurch gekennzeichnet, daß die Variablen zwei oder mehrere aus der Gruppe ausgewählte Variablen sind, die aus Frequenz, Spitzenspannung und Arbeitszyklus besteht.

20. Vorrichtung nach Anspruch 19, weiter umfassend ein Mittel (500, 502, 504, 506) zum Kodieren des einzelnen Datensignals mit einer einen Alarmpegel angebenden Variablen.

**Revendications**

1. Procédé de traitement et de lecture d'un signal de donnée unique ayant une pluralité de variables et représentant la valeur d'un paramètre, qui comprend :

(a) le codage électronique du signal de donnée unique avec une première variable indiquant l'étendue de mesurage de ladite valeur ;
(b) le codage électronique du signal de donnée unique avec une deuxième variable indiquant la grandeur de ladite valeur ;
(c) la lecture de la première variable dans le signal de donnée unique pour déterminer l'étendue de mesurage ; et
(d) la lecture de la deuxième variable dans le signal de donnée unique pour déterminer ladite valeur.

2. Procéde selon la revendication 1, qui comprend en outre les étapes suivantes :

(e) le codage électronique du signal de donnée unique avec une troisième variable indiquant ledit paramètre que représente la donnée ; et
(f) la lecture de la troisième variable dans le signal de donnée unique, pour déterminer ledit paramètre que représente la donnée.

3. Procédé selon la revendication 1, caractérisé en ce que la première et la deuxième variables sont choisies parmi l'ensemble comprenant la fréquence, la tension de crête et le cycle de service.

4. Procédé selon l'une quelconque des revendications précédentes, caractérisé en ce que les variables sont lues à l'aide d'un multimètre numérique.

5. Procédé selon la revendication 1, dans lequel on lit au moins un signal de donnée unique additionnel ayant une autre valeur et représentant un autre paramètre, ledit au moins un signal de donnée unique additionnel étant électroniquement codé avec une première variable indiquant l'étendue de mesurage de la valeur et étant électroniquement codée avec une deuxième variable indiquant la grandeur de la valeur, ce procédé comprenant en outre :

(a) le codage de chacun des signaux de donnée unique avec une troisième variable qui identifie le paramètre et uniquement lui ;
(b) la sélection séquentielle de l'un des signaux de donnée unique codés ;
(c) l'utilisation d'un multimètre numérique pour lire la troisième variable indiquant le paramètre ;
(d) l'utilisation du multimètre numérique pour lire la première variable indiquant l'étendue de mesurage ;

et

(e) l'utilisation du multimètre numérique pour lire la deuxième variable indiquant la grandeur de ladite valeur du paramètre.

6. Procédé selon la revendication 1, dans lequel on lit au moins un signal de donnée unique additionnel ayant une autre valeur et représentant un autre paramètre, ledit au moins un signal de donnée unique additionnel étant électroniquement codé avec une première variable indiquant l'étendue de mesurage de la valeur et étant électroniquement codée avec une deuxième variable indiquant la grandeur de la valeur, le procédé comprenant en outre :

(a) la fourniture, à chaque signal de donnée unique, d'une troisième variable indiquant à titre exclusif l'identité du paramètre ;

(b) la sélection séquentielle de l'un des signaux de donnée unique codés ;

(c) l'utilisation d'un multimètre numérique pour lire la troisième variable indiquant l'identité du paramètre ;

(d) l'utilisation du multimètre numérique pour lire la première variable, pour indiquer l'étendue de mesurage de ladite valeur ; et

(e) l'utilisation du multimètre numérique pour lire la deuxième variable, indiquant la grandeur de ladite valeur.

7. Procédé selon l'une quelconque des revendications 2, 5 et 6, caractérisé en ce que les variables sont deux variables ou plus choisies parmi l'ensemble comprenant la fréquence, la tension de crête et le cycle de service.

8. Procédé selon la revendication 3 ou la revendication 7, qui comprend en outre le codage du signal de donnée unique avec une variable indiquant un niveau d'alarme.

9. Appareil pour traiter et lire un premier signal de donnée unique ayant une pluralité de variables et représentant la valeur d'un paramètre, qui comprend :

(a) des moyens (302, 304, 306, 308) pour le codage électronique du premier signal de donnée unique avec une première variable indiquant l'étendue de mesurage de ladite première valeur ;

(b) des moyens (302, 304, 306, 308) pour le codage électronique du premier signal de donnée unique avec une deuxième variable indiquant la grandeur dudit premier signal de donnée ;

(c) des moyens (310, 312, 314, 316, 320, 322, 324, 600) pour lire la première variable dans le premier signal de donnée unique, pour déterminer l'étendue de mesurage ; et

(d) des moyens (310, 312, 314, 316, 320, 322, 324, 600) pour lire la deuxième variable dans le premier signal de donnée unique, pour déterminer la valeur de la donnée.

10. Appareil selon la revendication 9, qui comprend en outre :

(e) des moyens (302, 304, 306, 308) pour le codage électronique du signal de donnée unique avec une troisième variable indiquant le paramètre que représente la donnée ; et

(f) des moyens (310) pour lire la troisième variable dans le signal de données unique, pour déterminer le para-mètre que représente la donnée.

11. Appareil selon la revendication 9, caractérisé en ce que la première et la deuxième variables sont choisies parmi l'ensemble comprenant la fréquence, la tension de crête et le cycle de service.

12. Appareil selon la revendication 10, caractérisé en ce que les variables sont deux variables ou plus, choisies parmi l'ensemble comprenant la fréquence, la tension de crête et le cycle de service.

13. Appareil selon l'une quelconque des revendications 9 à 12, caractérisé en ce que les moyens (310) de lecture comprennent un multimètre numérique.

14. Appareil selon la revendication 12, qui comprend en outre :

(a) des moyens (502, 504, 506, 608) pour le codage électronique du signal de donnée unique avec une variable choisie parmi l'ensemble indiquant une situation d'alarme ; et

(b) des moyens (310) pour lire ladite variable dans le signal de donnée unique, pour déterminer si existe une situation d'alarme.

15. Appareil selon la revendication 9, dans lequel au moins un deuxième signal de donnée unique ayant une autre valeur et représentant un autre paramètre est traité et lu, l'appareil comprenant en outre :

(a) une pluralité de moyens de codage (302, 304, 306, 308), dont chacun est destiné à être connecté à un dispositif appartenant à une pluralité de dispositifs, dont chacun contient un signal choisi parmi le premier signal de donnée unique et au moins un deuxième signal de donnée unique indiquant la valeur de l'un des paramètres, chacun des moyens de codage étant destiné à recevoir et à coder l'un des signaux choisi parmi le premier signal de donnée unique et au moins un deuxième signal de donnée unique avec une première variable indiquant d'une manière non ambiguë l'étendue de mesurage de ladite valeur, et à coder le signal choisi parmi le premier signal de donnée et au moins un deuxième signal de donnée avec une deuxième variable indiquant d'une manière non ambiguë le paramètre représenté par la première variable, et à coder le signal, choisi parmi le premier signal de donnée et au moins un deuxième signal de donnée, avec une troisième variable dont la grandeur indique la grandeur de ladite valeur dudit paramètre ;

(b) des moyens de connexion (326, 326', 326''), pour connecter l'appareil aux entrées d'un multimètre numérique ;

(c) des moyens (330) pour court-circuiter le moyen de connexion pendant un laps de temps présélectionné, pendant lequel aucun signal ne peut être détecté à travers le moyen de connexion ;

(d) des moyens compteurs et décodeurs (320, 320', 320'') pour sélectionner séquentiellement l'un des moyens de codage, pour envoyer aux moyens de connexion l'un des signaux choisis parmi le premier signal de donnée unique et au moins un deuxième signal de donnée unique ;

(e) des moyens d'impulsions manquantes (322, 322', 322'') pour détecter quand les moyens de connexion sont court-circuités ; et

(f) des moyens de court-circuit unique (324, 324', 324''), qui sont sensibles aux moyens d'impulsions manquantes, pour provoquer un incrément des moyens compteurs et décodeurs quand les moyens de connexion sont court-circuités.

16. Appareil selon la revendication 9, dans lequel au moins un deuxième signal de donnée unique ayant une autre valeur et représentant un autre paramètre est traité et lu, l'appareil comprenant en outre :

(a) une pluralité de moyens de codage (302, 304, 306, 308), chacun servant à une connexion à un dispositif choisi parmi une pluralité de dispositifs, dont chacun contient un signal choisi parmi le premier signal de donnée unique et au moins un deuxième signal de donnée unique, indiquant la valeur de l'un des paramètres, chacun des moyens de codage étant destiné à coder l'un des signaux choisi parmi le premier signal de donnée unique et au moins un deuxième signal de donnée unique avec une première variable indiquant d'une manière non ambiguë l'étendue de mesurage de ladite valeur, et à coder le signal choisi parmi le premier signal de donnée et au moins un deuxième signal de donnée avec une deuxième variable, la grandeur de cette deuxième variable indiquant la grandeur de ladite valeur dudit paramètre ;

(b) des moyens (302, 304, 306, 308) pour fournir à chaque paramètre une troisième variable d'identification, indiquant l'identité du paramètre ;

(c) des moyens de connexion (326, 326', 326'') pour connecter l'appareil aux entrées d'un multimètre numérique ;

(d) des moyens (330) pour court-circuiter les moyens de connexion pendant un laps de temps présélectionné pendant lequel aucun signal ne peut être détecté à travers les moyens de connexion ;

(e) des moyens compteurs et décodeurs (320, 320', 320''), pour sélectionner sequentiellement l'un des moyens de codage, pour fournir aux moyens de connexion un signal choisi parmi le premier signal de donnée unique et au moins un deuxième signal de donnée unique ;

(f) des moyens de commutation (312, 314, 316, 318, 312', 314', 316', 318') pour fournir sélectivement aux moyens de connexion l'un des signaux de donnée unique ou ladite variable d'identification caractéristique dudit un signal choisi parmi le premier signal de donnée unique et au moins un deuxième signal de donnée unique ;

(g) des moyens d'impulsions manquantes (322, 322', 322''), pour détecter quand les moyens de connexion sont court-circuités ; et

(h) des moyens uniques de court-circuit (324, 324', 324''), qui répondent aux moyens d'impulsions manquantes pour incrémenter les moyens compteurs et décodeurs quand les moyens de connexion sont court-circuités, pour faire en sorte que les moyens de commutation donnent aux moyens connexion la troisième variable d'identification, caractéristique dudit un signal choisi parmi le premier signal de donnée unique et au moins un deuxième signal de donnée unique pour un certain intervalle de temps, puis pour faire en sorte que les moyens de commutation donnent aux moyens de connexion la première variable indiquant l'étendue de mesurage de ladite valeur.

**17.** Appareil selon la revendication 15 ou la revendication 16, qui comprend en outre :

(a) des moyens de circuit de remise à zéro (Figure 6) connectés à au moins un dispositif de ladite pluralité de dispositifs, pour leur remise à zéro, les moyens de circuit ayant des moyens d'entrée (520) pour fournir des entrées sélectivement logiques "1" ou "0", une sortie sélectionnée, à partir de laquelle lesdits moyens de circuit de remise à zéro assurent une remise à zéro dudit au moins un dispositif choisi parmi la pluralité de dispositifs ; et

(b) les moyens d'entrée (520) pour donner sélectivement une entrée logique "1" ou une entrée logique "0" pendant un premier laps de temps sélectionné, à la fin duquel les moyens de circuit de remise à zéro fournissent la sortie sélectionnée.

**18.** Appareil selon la revendication 17, caractérisé en ce que les moyens de circuit de remise à zéro ne fournissent la sortie sélectionnée qu'après la fin de l'autre entrée logique "1" ou "0" pour un deuxième laps de temps sélectionné après le premier laps de temps sélectionné.

**19.** Appareil selon la revendication 15 ou la revendication 16, caractérisé en ce que les variables sont constituées d'au moins deux variables choisies parmi l'ensemble comprenant la fréquence, la tension de crête et le cycle de service.

**20.** Appareil selon la revendication 19, qui comprend en outre des moyens (500, 502, 504, 506) pour coder ledit signal de donnée unique avec une variable indiquant un niveau d'alarme.

FIG. 1
(PRIOR ART)

EP 0 537 144 B1

17

FIG. 2

FIG. 3

FIG. 4

**FIG. 5**

THERMAL SENSOR    500

CLOCK

504

ELAPSED TIME COUNTER    502

1    3    10    30    100

15R    10R    6R    3R    1R

COM    5R

+5    7.5R

AMPLITUDE MODULATOR    506

DATA SIGNAL

DATA SIGNAL HAVING AMPLITUDE OF ALARM LEVEL

21

FIG. 6

FIG. 7A

FIG. 7B